(19) Europäisches Patentamt
European Patent Office
Office européen des brevets

(11) EP 0 780 485 B1

(12) **FASCICULE DE BREVET EUROPEEN**

(45) Date de publication et mention de la délivrance du brevet:
**30.08.2000 Bulletin 2000/35**

(51) Int Cl.[7]: **C23C 14/02**, C23C 16/02, C23G 5/00

(21) Numéro de dépôt: **96203581.2**

(22) Date de dépôt: **17.12.1996**

(54) **Procédé et dispositif pour le décapage d'un substrat métallique**

Verfahren und Vorrichtung zum Reinigen eines Metallsubstrats

Method and apparatus for cleaning a metal substrate

(84) Etats contractants désignés:
**AT BE CH DE DK ES FI FR GB GR IE IT LI LU NL PT SE**
Etats d'extension désignés:
**AL LT LV RO SI**

(30) Priorité: **20.12.1995 BE 9501053**

(43) Date de publication de la demande:
**25.06.1997 Bulletin 1997/26**

(73) Titulaire: **RECHERCHE ET DEVELOPPEMENT DU GROUPE COCKERILL SAMBRE,**
**en abrégé: RD-CS**
**4000 Liège (BE)**

(72) Inventeurs:
- **Vanden Brande, Pierre**
  **1040 Bruxelles (BE)**
- **Lucas, Stéphane**
  **5020 Suralée (BE)**
- **Weymeersch, Alain**
  **1300 Wavre (BE)**

(74) Mandataire: **Callewaert, Jean et al**
**Gevers & Vander Haeghen,**
**Patent Attorneys,**
**Rue de Livourne 7**
**1060 Brussels (BE)**

(56) Documents cités:
**EP-A- 0 535 568**
**DD-A- 136 047**
**FR-A- 2 708 290**
**GB-A- 2 086 943**

- **THIN SOLID FILMS, vol. 51, no. 2, 1 Juin 1978, pages 189-196, XP000644607 S. SCHILLER: "Pretreatment of metallic substrates with the plasmatron"**
- **CHEMICAL ABSTRACTS, vol. 89, no. 26, 1 Décembre 1978 Columbus, Ohio, US; abstract no. 219278t, D.W.TOMKINS: "An investigation of the factors affecting the cathodic etching for cleaning metal surfaces prior to ion-plating" page 244; XP002010807 & "Proc. - Conf. Ion Plat. Allied Tech. 1977" , CEP CONSULTANTS LTD. , EDINGBURGH, GB**
- **PATENT ABSTRACTS OF JAPAN vol. 010, no. 023 (C-325) [2080] , 29 Janvier 1986 & JP 60 174873 A (HITACHI DENSEN KK), 9 Septembre 1985,**
- **ADHASION, vol. 36, no. 6, 1 Juin 1992, pages 21-23, XP000277484 NITSCHKE B: "PLASMAREINIGUNG ALS VOLLSTAENDIGER ERSATZ FUER FCKW"**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).



Printed by Jouve, 75001 PARIS (FR)

## Description

La présente invention concerne un procédé pour le décapage d'un substrat métallique se présentant sous forme d'une bande continue telle qu'une tôle d'acier, suivant lequel on crée, à proximité de la surface du substrat à décaper un plasma, ce substrat étant polarisé négativement par rapport à une anode agencée en regard de la surface à décaper.

Un tel procédé est décrit dans la publication de S. Schiller et al. intitulée "Pretreatment of metallic substrates with the plasmatron" et parue dans "Thin Solid Films" vol 51 n° Juin 1978 pages 189-196. Cette publication décrit un procédé de prétraitement d'une bande métallique d'acier ou d'aluminium par décapage magnétron au moyen d'un dispositif appelé "plasmatron" et ce dans le but de favoriser l'adhérence d'un revêtement déposé sur la bande métallique postérieurement à cette étape de prétraitement.

Un désavantage du procédé connu est que l'usage du dispositif appelé "plasmatron" nécessite de hautes densités de courants d'ions pour obtenir un haut rendement de décapage ce qui rend le procédé onéreux.

L'invention a pour but de remédier à cet inconvénient et de présenter un procédé efficace à haut rendement de décapage.

A cette fin un procédé suivant l'invention est caractérisé en ce que l'on réalise le plasma dans un mélange de gaz constitué d'un gaz inerte, de l'hydrogène et/ou des composés hydrogénés, de manière à générer des radicaux et/ou des ions, la pression dudit gaz variant de 13,3 Pa si le gaz est formé de 100 % d'hydrogène à 0,66 Pa, si le gaz est constitué de 100 % de gaz inerte, des pressions intermédiaires correspondant à des mélanges intermédiaires d'hydrogène et/ou de composés hydrogénés avec un gaz inerte, les rapports entre l'hydrogène et/ou les composés hydrogénés vis-à-vis du gaz inerte étant dégressifs d'une manière sensiblement continue pour des pressions décroissantes dans les mêmes proportions, un circuit magnétique étant disposé du côté du substrat opposé à la surface à décaper de ce dernier.

Il faut noter que la publication de Schiller et al. ne mentionne pas l'utilisation d'un mélange d'un gaz inerte avec de l'hydrogène ou d'un composé hydrogéné dans des conditions déterminées afin d'obtenir un décapage magnétron d'une bande métallique à cinétique maximale. La nécessité de devoir changer la composition du mélange gazeux en fonction de la pression de travail n'est pas considérée.

EP-A-0 535 568, traite également d'un procédé pour le décapage d'un substrat métallique mais ne mentionne également pas l'utilisation d'un mélange d'un gaz inerte et d'hydrogène ou d'un composé hydrogéné dans les conditions précisées par la présente invention. DD-A-136.047 qui traite aussi d'un tel procédé ne fait pas mention d'une relation entre la composition du mélange gazeux et la pression de travail.

Le document JP-A-60174873 Patent abstracts of Japan Vol 10. n° 023 (C-325) du 29-01-86 décrit un procédé de décapage d'un substrat métallique dont la composition chimique peut être très variable (cuivre, alliage de cuivre, fer ou un alliage de fer) polarisé négativement et faisant usage d'un plasma généré dans un mélange de gaz inerte et d'hydrogène dans des proportions comprises entre 0,1 et 10 % en volume à une pression supérieure ou égale à 0,0133 Pa.

Etant donné la composition gazeuse très variable du mélange et des teneurs trop faibles en hydrogène (inférieures à 10 %), la cinétique du décapage ne serait pas maximale si l'on effectuait un décapage en faisant usage d'un circuit magnétique alimenté par un courant continu à puissance constante d'une tôle d'acier douce dans les conditions envisagées dans ce document.

GB-A-2086943 décrit un procédé de dépôt par voie physique dont le but est de produire des dépôts durs et/ou décoratifs sur des substrats en acier. L'étape de revêtement est précédée par une étape de nettoyage dans des mélanges d'argon et d'hydrogène. Ce nettoyage est obtenu par simple décapage sans faire usage d'un circuit magnétique et sous une différence de potentiel de 1000V. Cette technique implique des temps de nettoyage beaucoup plus longs que ceux obtenus dans le procédé suivant la présente demande de brevet, notamment plusieurs dizaines de minutes, alors que dans le procédé suivant l'invention il s'agit de quelques secondes.

Suivant une forme de réalisation particulière de l'invention, afin de permettre l'obtention d'un procédé continu, l'on fait défiler le substrat en regard du circuit magnétique précité.

L'invention concerne également un dispositif permettant notamment la mise en oeuvre du procédé précité.

Ce dispositif est caractérisé par le fait qu'il comprend a) une enceinte sous vide, b) des moyens permettant de créer dans cette enceinte un plasma, ainsi que c) des moyens permettant de polariser négativement la surface à nettoyer d'un substrat introduit dans l'enceinte susdite par rapport à une anode agencée en regard de cette surface.

D'autres détails et particularités de l'invention ressortiront de la description donnée ci-après à titre d'exemple non limitatif, d'une forme de réalisation particulière du procédé et du dispositif suivant l'invention avec référence aux figures.

La figure 1 est une représentation sous forme de graphique de la vitesse de décapage en Angström (Å) par seconde en fonction de la pression et de la composition du milieu gazeux dans lequel le décapage a lieu.

La figure 2 représente un graphique montrant l'évolution de la concentration en vapeur d'eau dans le milieu gazeux en fonction de la pression et de la composition du milieu gazeux dans lequel le décapage a lieu.

La figure 3 est une représentation schématique d'une coupe transversale d'une forme de réalisation particulière du dispositif, suivant l'invention, pour le nettoyage d'un substrat métallique.

L'invention concerne un procédé pour le décapage d'un substrat métallique, plus particulièrement une tôle d'acier, en vue de son recouvrement ultérieur par un revêtement. En général, de telles tôles, sortant des laminoirs, présentent des couches superficielles de contamination, telle que des oxydes, qui ont un effet néfaste sur l'adhésion d'un revêtement appliqué ultérieurement sur cette tôle, par exemple, par électrolyse ou par immersion dans un bain de métal fondu.

Le procédé suivant l'invention consiste en fait à appliquer la technique connue de pulvérisation cathodique sur la surface à nettoyer d'un substrat métallique.

Ainsi, suivant ce procédé on crée, à proximité de cette surface, polarisée négativement par rapport à une anode agencée en regard de cette dernière, un plasma dans un mélange d'hydrogène, de composés hydrogénés et/ou un d'un gaz inerte, tel que de l'argon, de manière à générer des radicaux et/ou des ions permettant d'agir sur la surface à nettoyer. Il s'agit plus particulièrement d'espèces excitées dans un plasma froid à basse pression de l'ordre de 0,133 à 1333 Pa.

Ce plasma est maintenu à proximité de la surface du substrat au moyen d'un circuit magnétique de confinement des électrons, qui est donc avantageusement disposé à proximité de cette surface derrière le substrat, c'est-à-dire du côté opposé à celui où le plasma est formé.

Afin de permettre d'obtenir un procédé continu, la surface à traiter et le circuit magnétique sont en déplacement relatif l'un par rapport à l'autre.

Dans une configuration avantageuse, le substrat défile devant le circuit magnétique, ce dernier étant donc dans ce cas maintenu dans une position immobile.

Les radicaux hydrogénés produits dans la décharge du plasma permettent d'éliminer par réduction les oxydes métalliques sous forme de vapeur d'eau, tandis que les dérivés carbonés formés sont éliminés sous la forme de composés hydrocarbonés. Lorsque ce mélange contient un gaz inerte, notamment de l'argon, l'action de décapage s'effectue principalement par bombardement ionique. Cet effet mécanique permet d'activer la surface à nettoyer en éliminant, d'une part, des molécules d'eau adsorbées provenant de l'oxydation des radicaux d'hydrogène et, d'autre part, des oxydes ou dérivés carbonés.

Dans une forme de réalisation particulièrement avantageuse de l'invention, le circuit magnétique est du type DC magnétron, c'est-à-dire à courant continu, et la surface à nettoyer est maintenue à la masse.

Lorsque le substrat est formé d'une feuille sensiblement continue, cette dernière se déplace en regard du circuit magnétique, par exemple à une vitesse de l'ordre de 100 à 500 m/min, de préférence de l'ordre de 400 m/min.

Comme dans les procédés classiques de pulvérisation cathodique, le gaz inerte est introduit dans le plasma 2 formé dans l'enceinte 1 par des injecteurs 11 dirigés vers la bande métallique 4.

La gamme de pressions du mélange gazeux précité peut avantageusement varier de 133.3 Pa, pour un gaz contenant 100 % d'hydrogène et/ou de composés hydrogénés, à 0,66 Pa, pour un gaz contenant 100 % d'un gaz inerte, les pressions intermédiaires correspondant à des mélanges intermédiaires d'hydrogène et/ou de composés hydrogénés avec du gaz inerte avec des rapports entre l'hydrogène et/ou les composés hydrogénés vis-à-vis du gaz inerte dégressifs d'une manière sensiblement continue pour des pressions décroissantes dans les mêmes proportions.

Le décapage d'une tôle d'acier doux peut être expliqué par trois mécanismes principaux dans un mélange argon-hydrogène :

- la réduction de la couche superficielle en FeO, généralement d'une épaisseur de 5 nm, des aciers par l'hydrogène activé dans le plasma selon la réaction globale $FeO + H_2 \rightarrow Fe + H_2O$, et
- la pulvérisation de la couche superficielle en FeO par les ions d'argon, et
- la pulvérisation du fer par les ions d'argon.

A cet égard, il y a lieu de remarquer que la valeur de la vitesse d'érosion du FeO est généralement de l'ordre de la moitié de celle du fer en pulvérisation cathodique à 100 % d'argon.

Si la couche de contamination est formée d'oxyde de fer, les réactions essentielles intervenant pour son enlèvement peuvent en fait s'écrire comme suit :

$$H_2 \rightarrow 2H^{\cdot}$$

$$Ar \rightarrow Ar^{+} + e^{-}$$

$$FeO + 2H^{\cdot} \rightarrow Fe + H_2O^{\nearrow}$$

$$Fe + Ar^{+} + e^{-} \rightarrow Ar^{\nearrow} + Fe^{\nearrow}$$

Des expériences ont été conduites afin d'optimaliser les conditions de décapage, c'est-à-dire d'augmenter la cinétique de décapage.

Elles ont permis de distinguer, suivant l'invention, deux domaines particulièrement intéressants : un domaine de décapage à basse pression (pression < 6,66 Pa, voir Fig. 1) et un domaine de décapage à haute

pression (pression > 6,66 Pa, voir également Fig. 1).

Plus particulièrement, la figure 1 fait apparaître clairement qu'il y a intérêt à travailler en présence d'hydrogène et avec une pression la plus basse possible dans le régime dit à basse pression P comprise entre 0,266 Pa et 6,66 Pa, alors qu'il y a intérêt à travailler avec une pression la plus haute possible dans la régime dit à haute pression. A cet égard il y a lieu de noter que la pression doit être supérieure à 22,6 Pa si l'on veut dépasser la vitesse de décapage maximale que l'on peut atteindre en régime basse pression.

La figure 1 est construite à partir d'équations cinétiques de décapage établies empiriquement en fonction de la pression et de la composition du mélange gazeux. Dans cette figure ainsi que dans la figure 2, la courbe "A" se rapporte à une atmosphère d'hydrogène pur, la courbe "B" à une atmosphère contenant 80 % d'hydrogène et 20 % d'argon, tandis que la courbe "C", dans la figure 2, est relative à une atmosphère d'argon pur.

Dans le cas d'un atmosphère d'argon, la vitesse de décapage maximale est donnée par l'équation suivante :

$$v = -13*P*Dp+1,2*Dp \qquad (1)$$

dans laquelle

v : vitesse de décapage (Å/s)
P : pression totale (Pa)
Dp : densité de puissance (W/cm$^2$)

Le domaine de fonctionnement est le suivant :

$$0,266 \text{ Pa} < P < 13,3 \text{ Pa}.$$

En dessous de 0,266 Pa, la formation d'un plasma magnétron n'est pratiquement plus possible, alors qu'au-dessus de 13,3 Pa la thermalisation des ions d'argon dans le gaz devient suffisamment importante pour que la vitesse de décapage à l'argon pur tombe à zéro.

Dans le cas d'une atmosphère d'hydrogène, la vitesse de décapage maximale est donnée par l'équation suivante :

$$v = 14,3*P*Dp \qquad (2)$$

Lorsqu'on est en présence d'hydrogène pur le domaine de stabilité de la décharge correspond à des pressions comprises entre 1,33 Pa et 133.3 x 10$^2$ Pa.

Si l'on ajoute plus de 20 % d'argon dans le mélange, la limite inférieure du domaine de stabilité du plasma passe de 1,33 Pa à 0,266 Pa. A cet égard, il y a lieu de noter que l'argon stabilise la décharge à basse pression.

Dans le cas d'une atmosphère mixte d'argon et d'hydrogène (avec plus de 20 % d'argon dans le mélange), la vitesse de décapage maximale est donnée par l'équation suivante :

$$v = -25*P*Dp + 2,43*Dp \qquad (3)$$

Pour un domaine de stabilité du plasma identique à celui d'une atmosphère d'argon pur, il faut que la pression soit comprise entre 0,266 Pa et 13,3 Pa pour un débit minimum d'hydrogène fixé par l'équation suivante :

$$QH_2 = 22,4*L*l*v \qquad (4)$$

dans laquelle :

L : longueur utile de la zone de décapage (m)
l: : largeur de bande (m)
v : vitesse de décapage (Å/s)
QH2 : (sccm) cm$^3$ par minute

et pour une concentration en hydrogène inférieure ou égale à 80 %. Au-dessus de 80 % en hydrogène, la quantité de fer pulvérisé par l'argon diminue et on tend vers le cas du processus à haute pression en hydrogène plus lent que le processus à basse pression lorsque la pression est inférieure à 22,6 Pa.

En effet, la teneur en eau dans la phase vapeur est toujours inférieure pour le procédé à basse pression comparativement au procédé à haute pression.

Dès lors, le procédé à basse pression doit être choisi dans le cas où les débits d'hydrogène sont limités et également dans le cas où on ne fait pas usage de pièges, par exemple un piège à azote liquide, pour diminuer la teneur en eau dans la phase vapeur. En effet, à basse pression, le fer pulvérisé par les ions d'argon, qui se dépose sur un blindage de récupération situé en face de la zone de décapage (par hypothèse d'aire équivalente à l'aire de la zone décapée) se réoxyde immédiatement au contact de la vapeur d'eau. Cette réoxydation du fer pulvérisé permet d'éliminer la vapeur d'eau qui n'est alors plus disponible pour la réoxydation de la tôle décapée.

Ce n'est évidemment pas le cas lorsqu'il n'y a pas de pulvérisation du fer par l'argon, c'est-à-dire à haute pression. Dans un tel cas, on doit impérativement diminuer la teneur en eau dans la phase vapeur en augmentant le débit de gaz, particulièrement en hydrogène, et/ou en plaçant des pièges, tels que des parois froides, pour condenser l'eau.

Il résulte par conséquent de ce qui précède que pour une pression P du milieu gazeux dans l'enceinte de décapage inférieure à 6,66 Pa, c'est-à-dire dans un régime à basse pression, le décapage optimal est obtenu par l'utilisation d'un groupe de pompage dimensionné de manière telle que "P" puisse varier de 0,26 Pa à 6,66 Pa, et est de préférence de l'ordre de 0,66 Pa pour avoir un plasma stable. Par ailleurs, il faut que le débit d'hydrogène "$QH_2$", suffisant pour réduire sensiblement toute la couche de FeO présente à la surface de la bande métallique à décaper, réponde à la relation $QH_2>22,4*L*l*v$ (voir équation 4) à la vitesse de ligne maximale admissible et que le débit d'argon soit fixé de manière à ce que la teneur en hydrogène soit inférieure à 80 %. A cet égard, il est généralement indiqué de travailler entre 20 et 50 % d'hydrogène. Il est important de noter que, dans ces conditions de travail, la tôle décapée n'est généralement pas sensible à une forte récontamination par l'eau produite lors de la réduction du FeO par de l'hydrogène. En effet, l'eau réoxyde immédiatement le fer pulvérisé sur le blindage du dispositif utilisé faisant face à la zone de décapage.

Pour une pression P du milieu gazeux dans l'enceinte de décapage supérieure à 6,66 Pa, c'est-à-dire dans un régime appelé "haute pression", le décapage optimal est obtenu par l'utilisation d'un groupe de pompage dimensionné de manière telle que P varie de 22,6 Pa à 6665 Pa, et soit de préférence de l'ordre de 133,3 Pa pour que la vitesse de décapage dépasse la valeur maximale obtenue dans la forme de réalisation définie ci-dessus du procédé suivant l'invention, appelée "régime basse pression".

Par ailleurs, il faut que, comme déjà mentionné ci-dessus, le débit d'hydrogène "$QH_2$" suffisant pour réduire sensiblement toute la couche de FeO présente à la surface de la bande métallique à décaper, réponde à la même relation que dans la forme de réalisation appelée "régime à basse pression". Contrairement à ce qui est le cas pour la forme de réalisation précédente, la forme de réalisation appelée "régime à haute pression" est bien sensible à la recontamination de la bande décapée par l'eau produite lors de la réduction du Fe par de l'hydrogène. Afin de diminuer cette recontamination, on peut, comme également déjà mentionné ci-dessus, augmenter le débit de gaz et éventuellement placer des pièges, par exemple sous forme de parois froides, pour condenser la vapeur d'eau formée.

Les deux formes de réalisation décrites ci-dessus sont illustrées davantage par les deux exemples concrets repris ci-après.

Exemple 1

Il s'agit d'un exemple réalisé dans le régime à basse pression

VL (vitesse de ligne) = 150 m/min.
L (longueur de traitement/face) = 2 m
l (longueur de bande) = 1 m
Dp = 26 $W/cm^2$
mélange : Ar + $H_2$ P = 0,66 Pa
Vitesse de décapage = 60 Å/s
Débit minimum d'hydrogène : 2600 sccm
Débit d'argon : 3000 sccm
Concentration en eau : ≅ 2 %Vol.$H_2O$

La concentration en eau est fonction du débit total et de la présence de parois froides. Sans parois froides, avec un débit total (Ar + $H_2$) = 27500 sccm, la teneur en eau dans le gaz était de 10 %.

Dans ces exemples "sccm" signifie "Standard cubic centimeter per minute" avec "Standard" correspondant aux conditions de travail de 1 atmosphère à 298 K. Ainsi, 1 sccm est égal à 1,69 litre/seconde ou encore $4,46.10^{17}$ molécules/seconde

La figure 3 montre une forme de réalisation particulière d'un dispositif pour la mise en oeuvre du procédé tel que décrit ci-dessus et appliqué à une bande métallique se déplaçant d'une manière sensiblement continue en regard d'un circuit magnétique.

Ce dispositif comprend une enceinte sous vide 1, des moyens, généralement connus en soi, permettant de créer dans cette enceinte 1 un plasma 2, et des moyens permettant de polariser négativement la surface à nettoyer 3 d'une bande métallique 4, formant le substrat, par rapport à une anode 5 agencée en regard de cette surface 3.

Un circuit magnétique 6 est agencé du côté opposé de la surface à nettoyer 3 de la bande 4 par rapport à l'anode 5.

Dans cette forme de réalisation particulière, la bande métallique 4 est appliquée, avec sa surface à nettoyer 3 dirigée vers l'extérieur, contre une partie de la paroi cylindrique d'un tambour creux 7 tournant autour de son axe 8 dans le sens de la flèche 9, de manière à entraîner cette bande 4 suivant un mouvement de translation continu dans le sens de la flèche 10.

Le circuit magnétique 6 est monté d'une manière immobile à l'intérieur du tambour 7, à proximité de la paroi cylindrique de ce dernier et en regard de la partie de cette paroi contre laquelle la bande 4 est appliquée. Le cas échéant, ce tambour 7 peut être refroidi intérieurement au niveau du circuit magnétique, par exemple à l'eau. De tels moyens de refroidissement n'ont toutefois pas été représentés à la figure 3.

Le circuit magnétique 6 est constitué d'une succession d'aimants, disposés alternativement nord "N" et sud "S", comme montré à la figure 3, et le tambour même est polarisé négativement. Celui-ci est de préférence réalisé dans un matériau non ferromagnétique.

Suivant un cas particulier de l'invention, le tambour 7 et, par conséquent, la bande métallique 4 se déplaçant sur ce dernier peuvent être mis à la masse, tandis que les parois de l'enceinte 1 peuvent être mises à un potentiel flottant.

Ci-après est donné un exemple concret de l'application de ce dispositif pour le décapage d'une tôle d'acier doux, dont la surface à nettoyer 3 présente une couche de 5 nm d'épaisseur d'oxyde de fer.

Cette tôle est entraînée dans l'enceinte 1 d'un dispositif, par le tambour 7 mis en rotation autour de son

axe 8, de manière à appliquer à la tôle une vitesse de ligne de l'ordre de 400 m/min. Les dimensions de l'enceinte 1 sont telles que la longueur de la zone de traitement de la tôle 4 dans le sens du déplacement de cette dernière sur le tambour 7 soit de l'ordre de 2 m, de sorte que le temps de traitement correspond à 0,3 seconde.

Il a été constaté que, dans le dispositif montré à la figure 3, la couche d'oxyde qui est présente sur la surface de la tôle peut être éliminée, dans un mélange d'argon et d'hydrogène à basse pression, en maintenant à cette tôle une densité de puissance de 40 W/$cm^2$.

C'est ainsi que, dans certains cas, la bande métallique 4 peut se déplacer suivant un mouvement rectiligne, par exemple au-dessus d'un support plan, en dessous duquel est monté le circuit magnétique. Le procédé peut convenir pour enlever des couches de contamination très variées étant donné que, surtout par les ions du gaz inerte, cet enlèvement peut avoir lieu uniquement d'une manière mécanique. L'épaisseur de la couche de contamination peut par exemple varier entre 1 et 50 nm, notamment dans le cas où celle-ci est essentiellement constituée d'oxyde de fer. Des moyens également mécaniques, connus en soi, peuvent être prévus pour évacuer les particules de contamination enlevées de la bande métallique.

## Revendications

1. Procédé pour le décapage d'un substrat métallique se présentant sous forme d'une bande continue telle qu'un tôle d'acier, suivant lequel on crée, à proximité de la surface du substrat à décaper un plasma, ce substrat étant polarisé négativement par rapport à une anode agencée en regard de la surface à décaper, caractérisé en ce que l'on réalise le plasma dans un mélange de gaz constitué d'un gaz inerte, de l'hydrogène et/ou des composés hydrogénés, de manière à générer des radicaux et/ou des ions, la pression dudit gaz variant de 13,3 Pa si le gaz est formé de 100 % d'hydrogène à 0,66 Pa, si le gaz est constitué de 100 % de gaz inerte, des pressions intermédiaires correspondant à des mélanges intermédiaires d'hydrogène et/ou de composés hydrogénés avec un gaz inerte, les rapports entre l'hydrogène et/ou les composés hydrogénés vis-à-vis du gaz inerte étant dégressifs d'une manière sensiblement continue pour des pressions décroissantes dans les mêmes proportions, un circuit magnétique étant disposé du côté du substrat opposé à la surface à décaper de ce dernier.

2. Procédé suivant la revendication 1, caractérisé en ce que l'on soumet la surface précitée et le circuit magnétique à un déplacement relatif l'un par rapport à l'autre.

3. Procédé suivant la revendication 2, caractérisé en ce que l'on fait défiler le substrat en regard du circuit magnétique précité.

4. Procédé suivant l'une quelconque des revendications 1 à 3, caractérisé en ce que l'on fait usage d'un substrat formé d'une feuille sensiblement continue se déplaçant en regard du circuit magnétique, par exemple à une vitesse de l'ordre de 300 à 500 m/min, de préférence de l'ordre de 400 m/min.

5. Procédé suivant l'une quelconque des revendications 1 à 4, caractérisé en ce que l'on réalise le plasma à une pression de 13,3 à 1333 Pa des radicaux et/ou ions formés.

6. Procédé suivant l'une quelconque des revendications 1 à 5, caractérisé en ce que la surface précitée à décaper est mise à la masse.

## Claims

1. Method for cleaning a metal substrate in the form of a continuous strip, such as a steel sheet, in which a plasma is created near the surface of the substrate to be cleaned, this substrate being biased negatively with respect to an anode placed so as to face the surface to be cleaned, characterized in that the plasma is produced in a gas mixture consisting of an inert gas, of hydrogen and/or of hydrogen-containing compounds so as to generate radicals and/or ions, the pressure of the said gas varying from 13.3 Pa if the gas is formed from 100% hydrogen to 0.66 Pa if the gas consists of 100% inert gas, intermediate pressures corresponding to intermediate mixtures of hydrogen and/or hydrogen-containing compounds with an inert gas, the ratios of hydrogen and/or hydrogen-containing compounds to the inert gas decreasing more or less continuously for pressures decreasing in the same proportions, a magnetic circuit being placed on the opposite side of the substrate from that surface of the latter which is to be cleaned.

2. Method according to Claim 1, characterized in that the aforementioned surface and the magnetic circuit are subjected to a relative displacement one with respect to the other.

3. Method according to Claim 2, characterized in that the substrate is made to run past the aforementioned magnetic circuit.

4. Method according to any one of Claims 1 to 3, characterized in that use is made of a substrate formed from a substantially continuous sheet moving past the magnetic circuit, for example at a speed of about 300 to 500 m/min, preferably about 400 m/min.

**5.** Method according to any one of Claims 1 to 4, characterized in that the plasma is produced at a pressure of 13.3 to 1333 Pa of the radicals and/or ions formed.

**6.** Method according to any one of Claims 1 to 5, characterized in that the aforementioned surface to be cleaned is earthed.

**Patentansprüche**

**1.** Verfahren zum Reinigen eines metallischen Substrates, welches in Form eines Endlosbandes, wie beispielsweise eines Stahlbleches, vorliegt, gemäß dem nahe der zu reinigenden Substratoberfläche ein Plasma geschaffen wird,
wobei das Substrat in Bezug auf eine Anode, die gegenüber der zu reinigenden Oberfläche angeordnet ist, negativ polarisiert wird,
dadurch gekennzeichnet, dass

das Plasma in einer Gasmischung erzeugt wird, welche sich aus einem Inertgas, Wasserstoff und/oder wasserstoffhaltigen Verbindungen zusammensetzt,

so dass Radikale und/oder Ionen gebildet werden,

wobei der Druck dieses Gases von 13,3 Pa, wenn das Gas zu 100 % aus Wasserstoff gebildet wird, bis 0,66 Pa, wenn das Gas aus 100 % Inertgas besteht, variiert,

wobei dazwischen liegende Drücke dazwischen liegenden Mischungen aus Wasserstoff und/oder wasserstoffhaltigen Verbindungen mit einem Inertgas entsprechen,

und wobei sich die Verhältnisse von Wasserstoff und/oder den wasserstoffhaltigen Verbindungen zu Inertgas im wesentlichen kontinuierlich verringern, bei im gleichen Maße abnehmende "Drücke",

und wobei ein Magnetkreis nahe bei dem Substrat gegenüberliegend zu dessen zu reinigender Oberfläche angeordnet ist.

**2.** Verfahren gemäß Anspruch 1, dadurch gekennzeichnet, dass die vorerwähnte Oberfläche und der Magnetkreis relativ gegeneinander versetzt werden.

**3.** Verfahren gemäß Anspruch 2, dadurch gekennzeichnet, dass das Substrat an dem vorerwähnten Magnetkreis vorbei bewegt wird.

**4.** Verfahren gemäß einem der Ansprüche 1 bis 3, dadurch gekennzeichnet, dass ein Substrat verwendet wird, welches aus einer im wesentlichen kontinuierlichen Folie gebildet ist, die sich in Bezug auf den Magnetkreis bewegt, beispielsweise mit einer Geschwindigkeit in der Größenordnung von 300 bis 500 m/min, vorzugsweise in der Größenordnung von 400 m/min.

**5.** Verfahren nach einem der Ansprüche 1 bis 4, dadurch gekennzeichnet, dass das Plasma bei einem Druck von 13,3 bis 1333 Pa der gebildeten Radikale und/oder Ionen erzeugt wird.

**6.** Verfahren nach einem der Ansprüche 1 bis 5, dadurch gekennzeichnet, dass die vorerwähnte zu reinigende Oberfläche mit der Masse verbunden wird.

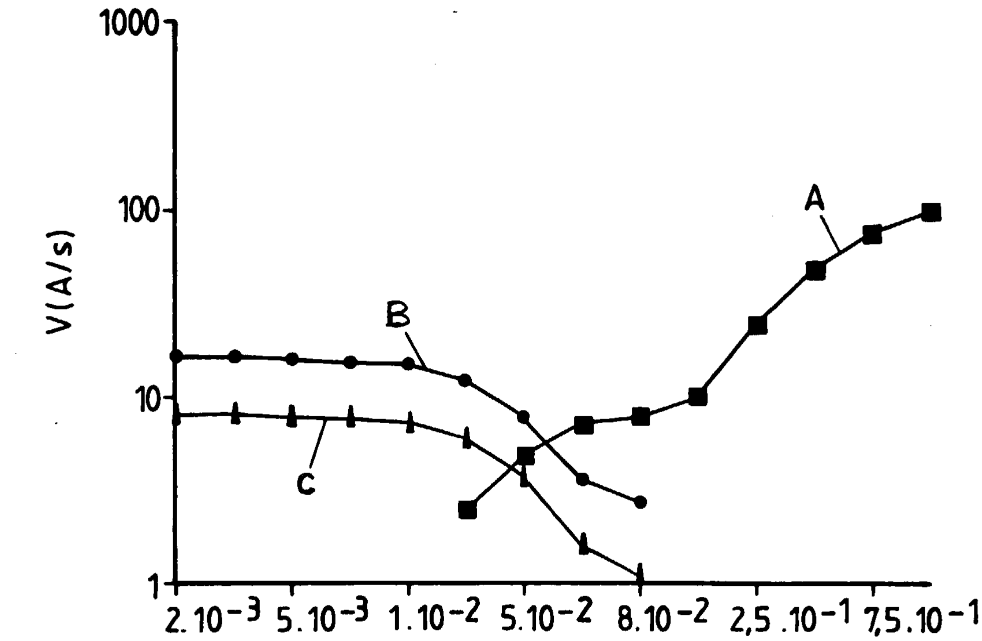


133,3 Pa

Fig.1

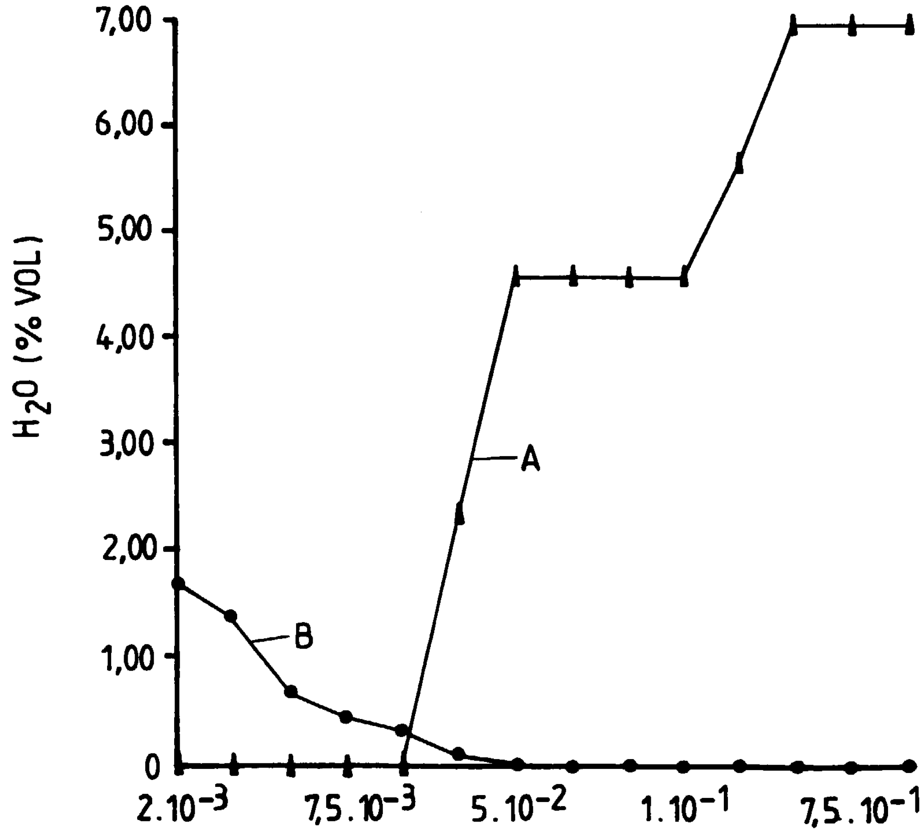


133,3 Pa

Fig.2

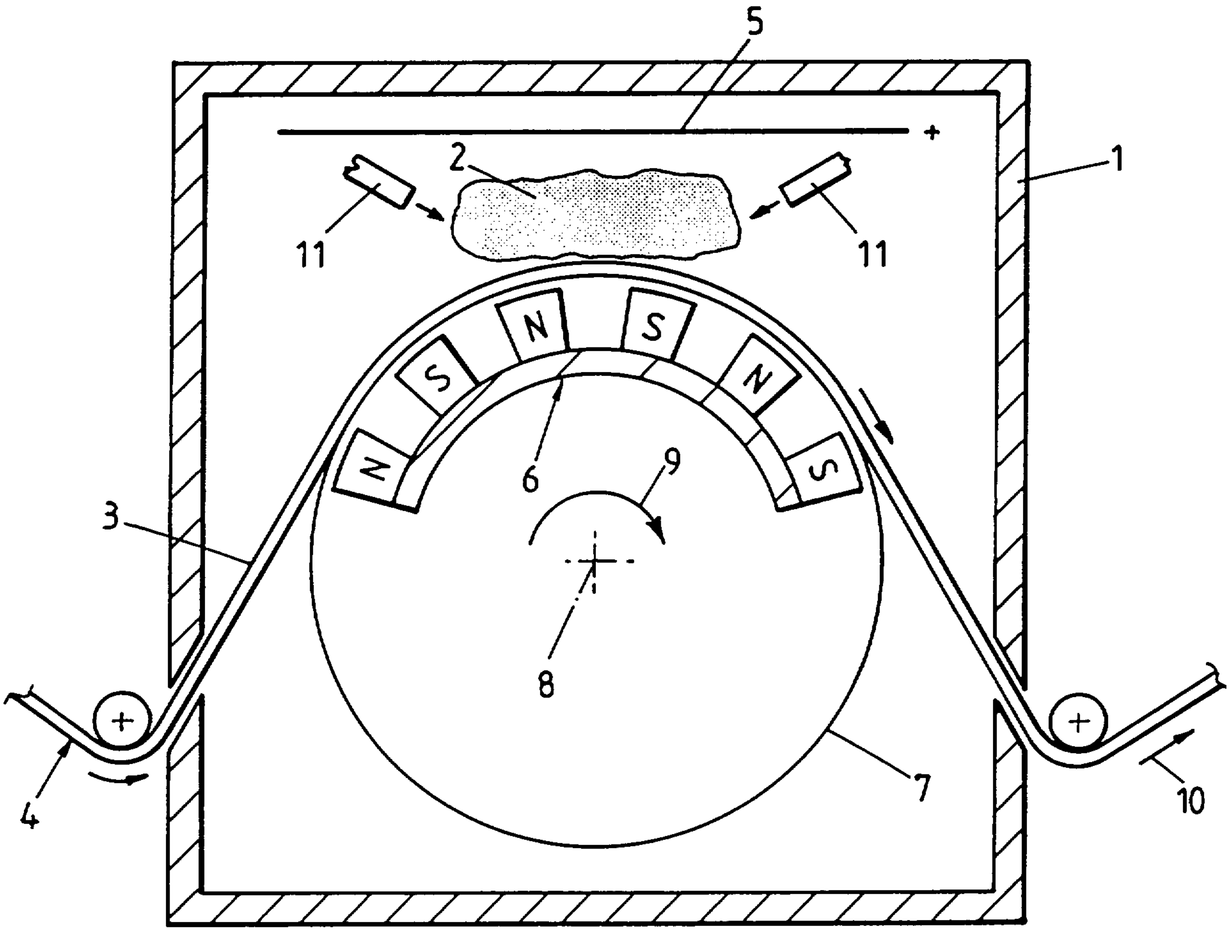


Fig.3